# EUROPÄISCHE PATENTSCHRIFT

(11) **EP 0 847 329 B1**
(45) Veröffentlichungstag und Bekanntmachung des Hinweises auf die Patenterteilung: **12.07.2000**
(21) Anmeldenummer: 96942998.4
(22) Anmeldetag: 24.08.1996
(51) Int. Cl.: B29C 67/00

(54) **VERFAHREN ZUR HERSTELLUNG VON 3-DIMENSIONAL STRUKTURIERTEN POLYMERSCHICHTEN FÜR DIE INTEGRIERTE OPTIK**
PROCESS FOR FABRICATING THREE-DIMENSIONALLY STRUCTURED POLYMER FILMS FOR INTEGRATED OPTICS
PROCEDE DE PRODUCTION DE COUCHES POLYMERES STRUCTUREES EN TROIS DIMENSIONS POUR L'OPTIQUE INTEGRE

(30) Priorität: 30.08.1995 DE 19531860; 30.07.1996 DE 19630705
(43) Veröffentlichungstag der Anmeldung: 17.06.1998
(73) Patentinhaber: Deutsche Telekom AG, 53113 Bonn (DE)
(72) Erfinder: KOOPS, Hans, W., P., D-64372 Ober-Ramstadt (DE); BABINE, Sergey, D-64347 Griesheim (DE)
(86) Internationale Anmeldenummer: DE9601579
(87) Internationale Veröffentlichungsnummer: WO9707970

(56) Entgegenhaltungen:
- MICROELECTRONIC ENGINEERING, Bd. 23, Nr. 1/04, 1.Januar 1994, Seiten 303-305, XP000418646 BABIN S V ET AL: "INVESTIGATION OF NEW DRY HIGH SENSITIVE RESIST USING 100 KV ELECTRON LITHOGRAPHY"
- THIN SOLID FILMS, Bd. 101, 1983, Seiten 369-372, XP000647428 KORCHKOV, T.N. ET AL: "All-dry vacuum submicron lithography" in der Anmeldung erwähnt
- MICROELECTRONIC ENGINEERING, Bd. 21, Nr. 1/4, 1993, AMSTERDAM, NL, Seiten 471-474, XP000361127 STEMMER, A. ET AL: "Design and fabrication of multilevel diffractive optical elements (DOEs) and holographic optical elements (HOEs)" in der Anmeldung erwähnt
- SPIE- THE INTERNATIONAL SOCIETY FOR OPTICAL ENGINEERING PROCEEDINGS, Bd. 2863, 5.August 1996, DENVER, COLORADO, USA, Seiten 95-101, XP000670809 BABIN, S. ET AL: "Dry resist technology to fabricate optimized micro-lenses centered to the end of a monomode fiber with electron beam lithography"
- JOURNAL OF VACUUM SCIENCE AND TECHNOLOGY, Bd. 14, Nr. 6, Dezember 1996, Seiten 3860-3863, XP000670940 BABIN, S. ET AL: "Three-dimensional electron beam lithography using an all-dry resist process"

## Beschreibung

Das erfindungsgemäße Verfahren ist auf die Erzeugung von 3-dimensional strukturierten, ausgebildeten Polymerschichten, insbesondere von optischen Linsen, ausgerichtet. Es findet insbesondere bei der Anpassung in Bezug auf die Emissions- oder Akzeptanz-Charakteristik einer optischen Faser oder eines optischen Lasers an einen runden Strahlengang Anwendung.

Linsen für die integrierte Optik werden insbesondere zur Kopplung von optischen Laser mit optischen Fasern eingesetzt.

Bei einer bekannten Lösung werden zur Kopplung von Lasern und Fasern mit lithographischen Verfahren Koppel-Taper direkt beim Aufbau der Laser ins Indium-Phosphid Grundmaterial mit eingebaut. Siehe
1.] R. Zengerle, H. J. Brückner, H. W. P. Koops, H.-J. Olzhausen, G. Zesch, A. Kohl, A. Menschig, "Fabrication of optical beamwidth transformers for guided waves on InP using wedge-shaped tapers", J. Vac. Sci. Technol. B 9 (6), (1991) 3459.
   Direkt an den Laser anschließende gekrümmte Grenzflächen mit fokussierender Wirkung in einem Schnitt, wie Zylinderlinsen, werden beispielsweise durch Nanolithographie mit Korpuskularstrahl-Lithographie definiert und durch reaktives Trockenätzen in zusätzlichen Prozeßschritten trocken geätzt. Siehe
2.] Unger, V. Boegli, P. Buchmann, R. Germann, "High resulution electron beam lithography for fabricating visible semiconductor lasers with curved mirrors and integrates holograms", Microelectronic Eng. 23, ((1994) 461.
   In mikromechanischer Manier werden auf angeätzte Glasfasern Glaskugeln justiert und aufgeklebt, die mit ihrer optischen Wirkung in beiden Richtungen rotationssymmetrisch das Emissionsprofil der Glasfaser auf bestimmte Weise anpassen. Siehe
3.] R. H. Bellmann, N. F. Borelli, J. Dafin, L. G. Mann, B. H. Raeder, ,,Precision Glass Microlens Array by a Photo-Thermal Technique", SPIE O-E Lase '88, January 14, (1988).
   Durch Anschmelzen der Faser und Verrunden im thermischen Prozeß als auch durch Laser-Ablation oder mechanische Politur können auf den Faserenden runde Abschlußprofile erzeugt werden.
   Als separate Baugruppen hergestellte Glaskörper mit geeigneten Krümmungen an den Enden werden als zwischengeschaltete Linse in den optischen Übertragungskanal eingeführt und erreichen so die entsprechende Koppelaufgabe. Die entsprechende Justierung auf Submikrometer genau stellt ein Problem dar. Siehe
4.] SMILE-Linsen werden hergestellt durch CORNING, France.
5.] GRIN-lenses hergestellt von NIPPON SHEET GLASS, Japan, NSG-Selfog product quide, NSG America Inc., Somerset, N. J. 08873.
   3-Dimensional strukturierte Polymerschichten als refraktiv arbeitende Linsen für die Integrierte Optik sind bisher nicht bekannt. Siehe
6.] R. Dändliker, R. Völkel, H. P. Herzig, W. B. Hugle, "Photolithographie with lenslet arrays", IG-Fachbericht 132 "Vacuumelektronik und Displays". (1995) 241,
7.] A. Stemmer, H. Zarschizky, F. Mayerhofer, G. Lefranc, H. W. Schneider, P. Galloway, SPIE. Vol. 1732 Holographics International'92, 77,
8.] A. Stemmer, H. Zarschizky, E. Knapek, G. Lefranc, H. Scherer-Winner, "Design and Fabrication of Multilevel Diffractive Optical Elements (DOEs) and Holographic Optical Elements (HOEs)", Microelectronic Engineering Vol. 21, No 1-4, (1993) 471-474,
9.] C. Dix, P. F. McKee, A. R. Thurlow, J. R. Towers, D. C. Wood, N. J. Dawes, J. T. Whitney, "Electron-beam fabrication and focused ion-beam inspection of submicron structured diffractive optical elements", J. Vac. Sci. Technol.B 12(6) (1994) 3708-37011 und
10.] P. D. Maker, R. E. Müller, "Phase holograms in polymethylmethacrylate", J. Vac. Sci. Technol. B 10(6) (1992) 2516.
   Versuche werden auch durchgeführt in der Gasentladung Elektronen-empfindliche Polymerisate zu erzeugen, deren Anwendungen noch offen stehen. Siehe
11.] O. Joubert, T. Weidmann, A. Joshi, R. Cirelli, S. Stein, J. T. C. Lee, S. Vaidya, Plasma polymerized all- dry resist process for 0.25 um photolithography", J. Vac. Technol. B 12(6) (1994) 3909.
   Am Techno-Centre in Moskau wurde für die Korpuskularstrahl- und optische Lithographie eine Substanz als Trockenlack synthetisiert, der mit einer Empfindlichkeit ähnlich der des bekannten Elektronenlackes PMMA (Polymethylmetacrylat) arbeitet. Dieser Lack besitzt ein für Lithographie geeignetes Auflösungsvermögen und wird im Vakuum aufgedampft und auch im Vakuum trocken entwickelt. Nasse Prozeßschritte werden überflüssig. Dadurch ist der Lack sehr umweltfreundlich.
12.] S. V. Babin, A. I. Holopkin, M. N. Lyakhoy, K. A. Valiev, L. V. Velikov, E. N. Zhikharev, "Investigation of new dry high sensitive resist using 100 kV electron lithography," Microelectronic Engineering 23 (1994) 303
13.] V. P. Korchkov, T. N. Martynova, V. S. Damlovich, Thin Solid Films 4 (1983) 3696
   Mit Korpuskularstrahl-induzierter Deposition ist es möglich, aus der Gasphase adsorbierte Monomere lokal in Polymere zu überführen. Dieses Verfahren benötigt keine Entwicklung bei der Herstellung von 3-dimensionalen Polymerstrukturen. Siehe
14. H. W. P. Koops, R. Weiel, D. P. Kern, T. H. Baum, "High Resolution Electron Beam Induced Deposition", Proc. 31. Int. Symp. on Electron, Ion an Photon Beams, J. Vac. Sci. Technol. B 6 (1) (1988) 477.

Das erfindungsgemäße Verfahren basiert auf der Verwendung eines polymerisierbaren Trockenlackes und der gezielten Belichtung des Trockenlackes unter Einbeziehung des Verfahrens der Korpuskularstrahl-induzierten Deposition.

Als Trockenlack eignet sich beispielsweise durch Photonen- bzw. Korpuskularstrahlen polymerisierbarer Octavinylsilsesquioxan-Trockenlack.

Die Erfindung wird im Anspruch 1 definiert, bevorzugte Ausführungen werden in den Unteransprüchen beschrieben.

Der polymerisierbare Trockenlack wird auf die Endoberfläche einer optischen Struktur aufgebracht und in einem Bereich belichtet, der der Form der gewünschten optischen Linse entspricht. Der zu belichtende Bereich wird vorzugsweise über bildverarbeitende Methoden bestimmt, mit denen der für die Linse vorberechnete Strukturbereich mit Submikrometer-Präzision festgelegt wird. Dieser Bereich wird einem gesteuerten Belichtungsprozeß ausgesetzt. Die für den Belichtungsprozeß notwendigen Belichtungsparameter, d. h. die räumlich und zeitlich notwendige Dosisverteilung der Strahlung, werden in Abhängigkeit von der gewünschen Form der Linse ermittelt. Der Belichtungsprozeß wird dann automatisch mittels rechnertechnischer Steuerungsverfahren durchgeführt.
Anschließend wird der durch die Belichtung polymerisierte linsenförmige Strukturbereich aus dem nicht belichteten Trockenlack herausgearbeitet.
Für diesen Prozeß bieten sich mehrere Möglichkeiten an:
1. Der durch Belichtung polymerisierte linsenförmige Strukturbereich wird durch physikalisches Entwickeln, wie Heizen im Hochvakuum, aus dem Trockenlack herausgearabeitet.
2.Der durch Belichtung polymerisierte linsenförmige Strukturbereich wird durch physikalisches Entwickeln, wie Heizen an der Luft, aus dem Trockenlack herausgearbeitet.
3.Der durch Belichtung polymerisierte linsenförmige Strukturbereich wird durch trocken-chemisches Entwickeln, wie Bearbeiten in einer Gasentladung, aus dem Trockenlack herausgearabeitet.

Eine zweckmäßige Ausgestaltung der erfindungsgemäßen Verfahrens besteht darin, den als Ausgangssubstanz verwendeten polymerisierbaren Trockenlack vor der Belichtung auf der für die optische Linse vorgesehenen 3-dimensionalen optisch wirksamen Oberfläche aufzubringen. Diese Möglichkeit ist insbesondere bei optischen Fasern oder Laserlichtquellen vorteilhaft, deren optische Austrittsflächen an einen runden Strahlengang anzupassen sind.

Mittels des erfindungsgemäßen Verfahrens lassen sich miniaturisierte brechende Linsen mit sphärischer oder auch nichtsphärischer Geometrie herstellen. Durch Wahl verschiedener Profile in verschiedenen Raumrichtungen können spezielle Strahlcharakteristiken der Faser oder der Laser mit einer entsprechenden Korrektur versehen werden und die Emissions- oder Akzeptanz-Charakteristik auf ein rotationssymmetrisches Profil oder ein vorher definiertes Profil eingestellt werden. Ebenso können Prismen und Strahlteiler direkt hergestellt werden. Dabei werden diese Bauelemente durch trockenchemisches Entwickeln aus dem Lack herausgearbeitet.

In dieser Technik können auch auf Flächen Linsenarrays für die parallele optische Fokussierung vieler Bildpunkte in ein Arraymuster hergestellt werden, wie sie zur Steigerung der Empfindlichkeit von optischen Detektoren, von flachen Fernsehkameras oder von Diodenarrays benötigt werden. Das Verfahren eignet sich weiterhin zur Erzeugung von asphärische Flächen mit komplexen Schnittkurven. Dabei ist es möglich, die gewünschten Elemente mit Submikrometer-Präzision auf die erforderliche Einsatzstelle zu zentrieren.

Durch die Trockenlacktechnik wird die kleine Endfläche der Faser oder des Lasers in einem einfachen technologischen Verfahren mit einem Material belegbar, aus dem die optisch wirksame 3-dimensisonale Struktur gefertigt wird. Damit kann eine sonst nicht zugängliche Fläche mit hoher Präzision vorbearbeitet werden, um das geforderte Endprodukt genau plaziert zu fertigen. Durch die Lithographie im Raster-Elektronenmikroskop kann mit dem Einsatz der bildverarbeitenden Methoden die Struktur mit Submikrometer-Präzision auf die Faser oder den Laser plaziert werden und auf die vorliegende 3-dimensionale Oberfläche der Faser oder des Lasers angepaßt werden. Durch die nach der Belichtung anschließende thermische Entwicklung des Trockenlackes sind für die Fertigung keine naßchemischen Lösungsmittel nötig. Der erfindungsgemäße
Herstellungsprozeß wird damit als hochpräziser trockener Prozeß realisiert, der ohne großen Aufwand automatisierbar ist.
Das gilt auch für die Herstellung der Linsen aus im Korpuskularstrahl polymerisierenden adsorbierten Molekülen, die sich aus der Dampf-Phase während der Belichtung auf die Oberfläche setzen. Im Fall der Strahl-induzierten Deposition ist keine Entwicklung mehr erforderlich und das Produkt ist nach dem Aufwachsvorgang fertig. Durch geeignete Materialwahl können hochbrechende oder im Brechungsindex angepaßte Materialien als Linse oder auch als reflexvermindernde Schichtfolgen mit dieser Technik aufgebracht werden.
Die Materialauswahl geschieht durch Wechseln des Präkursor-Molekülstrahles und kann automatisiert und in den Belichtungs-Steuerungs-Prozeß eingebaut werden. Damit können gewünschte Brechzahlprofile und Strukturen erzeugt werden, die sonst nur durch mehrere komplexe Verfahrensschritte erzielt werden können.

## Patentansprüche

1. Verfahren zur Herstellung von 3-dimensional strukturierten Polymerschichten für die integrierte Optik unter Anwendung der Korpuskularstrahl-induzierten Deposition, **dadurch gekennzeichnet,**
- daß Trockenlacktechnologie angewandt wird, wobei ein durch Belichtung polymerisierbarer Trockenlack auf einem Träger aufgebracht wird,
- daß der Trockenlack mit einer räumlich und zeitlich vorgegebenen Dosisverteilung in einem durch bildverarbeitende Methoden mit Submikrometer-Präzision vorberechneten Strukturbereich, der die Form der gewünschten optischen Struktur aufweist, belichtet wird und
- daß der durch Belichtung polymierisierte Strukturbereich durch einen Trocken-Prozeß aus dem nicht belichteten Trockenlack herausgearbeitet wird.

2. Verfahren nach Anspruch 1 dadurch gekennzeichnet, daß als Trockenlack vorzugsweise durch Photonen- bzw. Korpuskularstrahlen polymerisierbarer Octavinylsilsesquioxan-Trockenlack zur Anwendung kommt.

3. Verfahren nach Anspruch 1 dadurch gekennzeichnet, daß der durch Belichtung polymerisierte Strukturbereich durch physikalisches Entwickeln, wie heizen im Hochvakuum, aus dem Trockenlack herausgearbeitet wird.

4. Verfahren nach Anspruch 1 dadurch gekennzeichnet, daß der durch Belichtung polymerisierte Strukturbereich durch physikalisches Entwickeln, wie Heizen an der Luft, aus dem Trockenlack herausgearbeitet wird.

5. Verfahren nach Anspruch 1 dadurch gekennzeichnet, daß der durch Belichtung polymerisierte Strukturbereich durch trocken-chemisches Entwickeln, wie Bearbeiten in einer Gasentladung, aus dem Trockenlack herausgearbeitet wird.

6. Verfahren nach Anspruch 1 dadurch gekennzeichnet, daß der als Ausgangssubstanz verwendete polymerisierbare Trockenlack vor der Belichtung auf der optischen Endfläche einer optischen Struktur aufgebracht wird.

7. Verfahren nach Anspruch 1 dadurch gekennzeichnet, daß als Ausgangssubstanzen durch den Korpuskularstrahl direkt polymerisierbare und niederschlagbare Organo-Polymere mit und ohne Metallgehalt während des Belichtens auf der optischen Endfläche einer optischen Struktur aufgebracht werden, und daß dabei durch Dosis-Steuerung ein polymerisierter Strukturbereich erzeugt wird.

## Claims

1. A process for producing three-dimensionally structured polymer layers for integrated optics, using corpuscular ray-induced deposition, characterised in that dry varnish technology is used, wherein a dry varnish polymerisable by exposure to light is applied to a substrate,
- in that the dry varnish, distributed in portions preset in space and time, is exposed to light over a structural zone having the form of the desired optical structure and pre-calculated with submicrometre precision by image-processing methods and
- in that the structural zone polymerisable by exposure to light is obtained from the non-exposed dry varnish by a drying process.

2. A process according to claim 1, characterised in that the dry varnish is preferably octavinylsilsesquioxane dry varnish polymerisable by photon or corpuscular rays.

3. A process according to claim 1, characterised in that the structural zone polymerisable by exposure to light is obtained from the dry varnish by physical development, e.g. heating in a high vacuum.

4. A process according to claim 1, characterised in that the structural zone polymerisable by exposure to light is obtained from the dry varnish by physical development, e.g. heating in air.

5. A process according to claim 1, characterised in that the structural zone polymerised by exposure to light is obtained from the dry varnish by dry chemical development, such as processing in a gas discharge.

6. A process according to claim 1, characterised in that the polymerisable dry varnish used as the starting substance is applied to the optical end surface of an optical structure before exposure.

7. A process according to claim 1, characterised in that the starting substances are organo-polymers with or without a metal content which can be directly polymerised and deposited by the corpuscular ray and are applied to the optical end surface of an optical structure during exposure, and in that a polymerisable structural zone is generated by dosage control.

## Revendications

1. Procédé pour la fabrication de couches en polymères structurées en trois dimensions pour l'optique intégrée, utilisant le dépôt induit par rayonnement corpusculaire, caractérisé en ce que
- on utilise la technologie à laque sèche, une laque sèche qui peut être polymérisée par exposition à la lumière étant appliquée sur un support,
- on expose à la lumière la laque sèche avec une répartition au dosage prescrit dans l'espace et dans le temps dans une zone de structure qui est calculée au préalable par des méthodes de traitement de l'image avec une précision sous-micrométrique et qui a la forme de la structure optique souhaitée, et en ce que
- au moyen d'un processus par voie sèche, on extrait de la laque sèche non exposée à la lumière la zone de structure polymérisée par exposition à la lumière.

2. Procédé selon la revendication 1, caractérisé en ce qu'on utilise comme laque sèche de préférence de la laque sèche en octavinylsil-sesquioxane pouvant être polymérisée par rayonnement photonique ou corpusculaire.

3. Procédé selon la revendication 1, caractérisé en ce qu'on extrait de la laque sèche la zone de structure polymérisée par exposition à la lumière grâce à un développement physique, comme le chauffage dans le vide très poussé.

4. Procédé selon la revendication 1, caractérisé en ce qu'on extrait de la laque sèche la zone de structure polymérisée par exposition à la lumière grâce à un développement physique, comme le chauffage à l'air.

5. Procédé selon la revendication 1, caractérisé en ce qu'on extrait de la laque sèche la zone de structure polymérisée par exposition à la lumière grâce à un développement chimique par voie sèche, comme le traitement dans une décharge gazeuse.

6. Procédé selon la revendication 1, caractérisé en ce qu'on applique la laque sèche utilisée comme substance de départ et pouvant être polymérisée, avant l'exposition à la lumière, sur la surface terminale optique d'une structure optique.

7. Procédé selon la revendication 1, caractérisé en ce qu'on applique des organo-polymères pouvant être polymérisés directement par rayonnement corpusculaire comme substances de départ et pouvant précipiter, avec et sans teneur en métal, pendant l'exposition à la lumière, sur la surface terminale optique d'une structure optique et en ce qu'on produit par une commande du dosage une zone de structure polymérisée.
